**Europäisches Patentamt**

**European Patent Office**

**Office européen des brevets**

(11) Numéro de publication : **0 410 533 B1**

(12) **FASCICULE DE BREVET EUROPEEN**

(45) Date de publication du fascicule du brevet :
**08.02.95 Bulletin 95/06**

(21) Numéro de dépôt : **90202009.8**

(22) Date de dépôt : **23.07.90**

(51) Int. Cl.⁶ : $G01S\ 1/56$, $G01R\ 19/30$

(54) **Procédé de réception d'impulsions de type M.L.S. et dispositif permettant la mise en oeuvre de ce procédé.**

(30) Priorité : **28.07.89 FR 8910186**

(43) Date de publication de la demande :
**30.01.91 Bulletin 91/05**

(45) Mention de la délivrance du brevet :
**08.02.95 Bulletin 95/06**

(84) Etats contractants désignés :
**DE FR GB IT**

(56) Documents cités :
**EP-A- 0 192 876**
**EP-A- 0 288 170**
**FR-A- 2 373 068**
**FR-A- 2 594 552**

(73) Titulaire : **THOMSON-TRT DEFENSE**
**Rue Guynemer**
**F-78280 Guyancourt (FR)**

(72) Inventeur : **Hethuin, Serge**
**SOCIETE CIVILE S.P.I.D.,**
**156, boulevard Haussmann**
**F-75008 Paris (FR)**

(74) Mandataire : **Courtellemont, Alain et al**
**THOMSON-CSF,**
**SCPI,**
**B.P. 329,**
**50, rue Jean-Pierre Timbaud**
**F-92402 Courbevoie Cédex (FR)**

## Description

La présente invention concerne un procédé de réception d'impulsions de type M.L.S, notamment, impliquant une première étape d'échantillonnage pour déterminer des valeurs d'échantillons de l'impulsion, jointes avec des dates de réception d'échantillons.

Un problème qui se pose avec ce type d'impulsion est de trouver la date à laquelle survient leur maximum. Il est important, en effet, de déterminer avec le plus de précision possible la date de ce maximum si on veut obtenir de bonnes performances d'un sytème de radionavigation M.L.S, par exemple.

Bien que l'invention ait trait plus particulièrement à ce système, il va de soi que l'invention couvre aussi les applications où l'on est confronté avec ce genre de problème.

La résolution de ce problème se heurte principalement à deux sortes de difficultés. La première provient du fait que les impulsions émises subissent différentes réflexions et sont reçues déformées. La deuxième est qu'elles peuvent être entachées par le bruit. En conséquence, le maximum détecté n'est pas exactement celui de l'impulsion émise.

Dans le document de brevet européen n° 0 192 876, on décrit un tel procédé qui prévoit des mesures pour résoudre ce problème. Cependant, ces mesures restent insuffisantes pour donner une date avec une bonne précision surtout lorsque les impulsions reçues sont noyées dans le bruit.

Selon l'invention il est proposé un procédé de réception d'impulsions de type M.L.S, notamment, impliquant une première étape d'échantillonnage pour déterminer des valeurs d'échantillons de l'impulsion et une date de réception pour chaque échantillon et avec cette étape, une recherche, pour chaque impulsion, d'une valeur maximum, caractérisé en ce qu'il consiste, dans la première étape, à rechercher comme valeur maximum, la valeur de l'échantillon maximum et en ce qu'il comporte les étapes suivantes :

- une deuxième étape pour déterminer pour une impulsion reçue, l'écart de valeurs entre la valeur maximum d'échantillon et un seuil prédéfini correspondant à un minimum de réception,
- une troisième étape pour découper en zones ledit écart,
- une quatrième étape pour déterminer les amplitudes d'échantillons et les dates d'échantillons de chaque zone,
- une cinquième étape pour calculer, pour chaque zone, une date moyenne de zone et une amplitude moyenne,
- une sixième étape de réjection éventuelle de zone,
- une septième étape pour fournir la date de réception de l'impulsion à partir des dates moyennes de zone et des amplitudes moyennes.

La description suivante accompagnée des dessins ci-annexés, le tout donné à titre d'exemple non limitatif, fera bien comprendre comment l'invention peut être réalisée.

La figure 1 représente schématiquement un dispositif permettant la mise en oeuvre de l'invention.

La figure 2 montre une impulsion de type M.L.S pour laquelle le procédé de l'invention est appliqué.

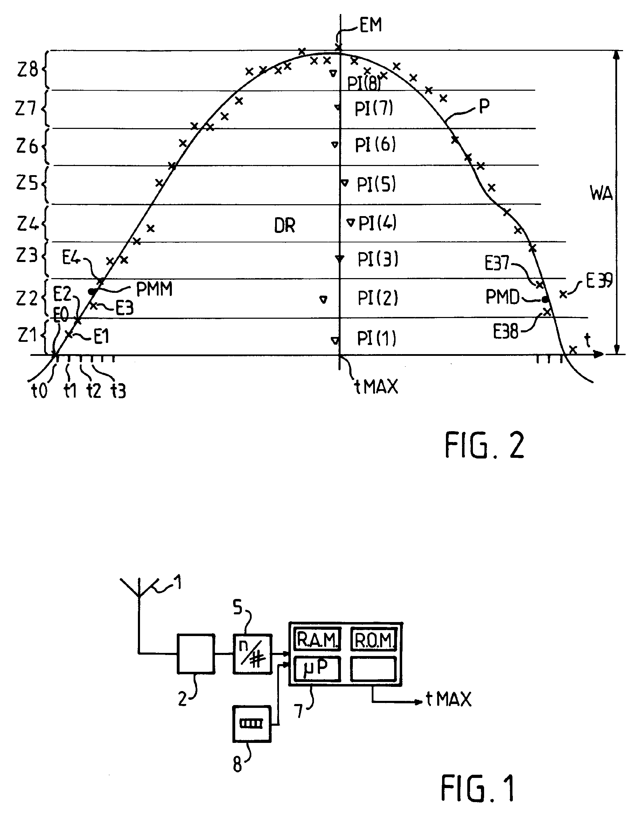

A la figure 1, la référence 1 indique l'antenne qui reçoit sur une porteuse l'impulsion, le récepteur 2 effectue les opérations usuelles d'amplification, de démodulation et autres de sorte qu'un convertisseur analogique-numérique 5 puisse fournir des échantillons accompagnés de leur date, dite date d'échantillon, à l'organe de traitement 7. La date d'échantillon est élaborée au moyen d'un organe de datation 8. L'organe de traitement 7 est constitué à partir d'un microprocesseur autour duquel on trouve une mémoire vive, une mémoire morte qui contient notamment les informations de programme définissant le procédé de l'invention.

Le procédé de l'invention peut être expliqué à l'aide de la figure 2. Sur cette figure, on a représenté par des croix les différents échantillons E0, E1, E2, E3,...d'une impulsion P de type M.L.S. représenté en trait plein. A chacun de ces échantillons correspond une date d'échantillon t0, t1, t2, t3,...

Selon l'invention, on détermine la valeur maximale de tous les échantillons. Soit EM cet échantillon et AM son amplitude. On détermine aussi la valeur minimale de tous les échantillons, soit EO d'amplitude AO, ce peut être la valeur de seuil de détection connue a priori. Dans cet exemple décrit, on découpe en huit zones Z1, Z2,...,Z8 l'écart WA compris entre ces deux valeurs AM et AO. Ces zones délimitent des domaines d'amplitude DA de valeur : DA = WA/8 où WA = AM - AO.

Dans chaque zone on détermine une valeur moyenne d'amplitude associée à une valeur moyenne de datation ; ainsi pour la zone Z2 on a pour le front montant de l'impulsion P les échantillons E3 et E4 de dates t3 et t4 et pour le front descendant les échantillons E37, E38 et E39 ayant les dates respectives t37, t38, et t39 ; on calcule d'abord la valeur moyenne des amplitudes VMM pour le front montant :

$$VMM = (E3 + E4)/2$$

puis la valeur moyenne des dates tMM

$$tMM = (t3 + t4)/2$$

On a porté sur la figure 2 le point PMM de coordonnées VMM et tMM.

Pour le front descendant, la valeur moyenne des amplitudes VMD :

$$VMD = (E37 + E38 + E39)/3$$

et la valeur moyenne des dates tMD :

$$tMD = (t37 + t38 + t39)/3$$

ces coordonnées déterminent le point PMD.

A partir de ces valeurs, on détermine les points moyens VI(i) et TI(i) pour chaque zone "i". Ainsi pour la zone Z2 :

$$VI(2) = (VMD + VMM)/2$$
$$TI(2) = (tMD + tMM)/2$$

On obtient ainsi plusieurs points, PI(i) représentés à la figure 2.

Sur ces points VI(i) et TI(i) relatifs à N' zones on effectue une régression linéaire. En effet, il convient de ne pas considérer toutes les zones et de rejeter celles qui n'apportent aucune information significative. N' est le nombre restant de zones possibles après :

- l'élimination des zones où aucune information soit dans le front montant soit dans le front descendant n'est disponible.
- l'élimination de zones à forte perturbation éventuelle.

Pour effectuer cette régression linéaire on calcule tout d'abord les valeurs moyennes de barycentre suivantes VRL et TRL :

$$VRL = \frac{1}{N'} \sum_{i=1}^{N} VI(i)$$

$i \neq$ zones rejetées

$$TRL = \frac{1}{N'} \sum_{i=1}^{N} TI(i)$$

$i \neq$ zones rejetées

Pour une plus grande rapidité de calcul, on calcule uniquement :

$$vm = \sum_{i=1}^{N} VI(i)$$

$i \neq$ zones rejetées
et

$$tm = \sum_{i=1}^{N} TC(i)$$

$i \neq$ zones rejetées

On détermine ensuite les valeurs centrées VC(i) et TC(i)

$$VC(i) = N'.VI(i) - vm$$
$$TC(i) = N'.TI(i) - tm$$

$i$ : désignant les zones non rejetées.

On détermine ensuite la droite de régression DR qui passe au mieux à travers les points PI(i). Cette droite DR a pour pente "p".

$$p = (\sum_{i=1}^{N} VC(i).TC(i)) / (\sum_{i=1}^{N} VC(i)^2)$$

$i \neq$ zones rejetées
d'où finalement $t$ MAX :

$$t\,MAX = \frac{1}{N'}[p.(N'.AM - vm) + tm]$$

## Revendications

1. Procédé de réception d'impulsions de type M.L.S, notamment, impliquant une première étape d'échantillonnage pour déterminer des valeurs d'échantillons de l'impulsion et une date de réception pour chaque échantillon et avec cette étape, une recherche, pour chaque impulsion, d'une valeur maximum, caractérisé en ce qu'il consiste, dans la première étape, à rechercher comme valeur maximum, la valeur de l'échantillon maximum et en ce qu'il comporte les étapes suivantes :

   - une deuxième étape pour déterminer pour une impulsion reçue, l'écart de valeurs entre la valeur maximum d'échantillon et un seuil prédéfini correspondant à un minimum de réception,
   - une troisième étape pour découper en zones ledit écart,
   - une quatrième étape pour déterminer les amplitudes d'échantillons et les dates d'échantillons de chaque zone,
   - une cinquième étape pour calculer, pour chaque zone, une date moyenne de zone et une amplitude moyenne,
   - une sixième étape de réjection éventuelle de zone,
   - une septième étape pour fournir la date de réception de l'impulsion à partir des dates moyennes de zone et des amplitudes moyennes.

2. Procédé selon la revendication 1, caractérisé en ce que la septième étape implique une régression linéaire.

3. Procédé selon la revendication 1 ou 2, caractérisé en ce que, lors de la sixième étape, les zones n'apportant pas d'information significative sont éliminées.

4. Dispositif pour la mise en oeuvre du procédé selon la revendication 1, comportant des moyens d'échantillonnage (5, 8) pour recevoir des impulsions de type MLS et fournir, pour chaque impulsion, des échantillons faits chacun d'une valeur d'échantillon et d'une date d'échantillon et un organe de traitement (7), constitué à partir d'un microprocesseur, pour recevoir les échantillons et rechercher, pour chaque impulsion, une valeur maximum, caractérisé en ce que le microprocesseur est programmé pour

- dans la première étape, rechercher, comme valeur maximum, la valeur de l'échantillon maximum,
- dans une deuxième étape, déterminer pour une impulsion reçue, l'écart de valeurs entre la valeur de l'échantillon maximum et un seuil prédéfini correspondant à un minimum de réception,
- dans une troisième étape, découper en zones ledit écart,
- dans une quatrième étape, déterminer les amplitudes d'échantillons et les dates d'échantillons dans chaque zone,
- dans une cinquième étape, calculer, pour chaque zone, une date moyenne de zone et une amplitude moyenne,
- dans une sixième étape, effectuer une réjection éventuelle de zone,
- dans une septième étape, fournir la date de réception de l'impulsion à partir des dates moyennes de zone et des amplitudes moyennes.

**Patentansprüche**

1. Verfahren zum Empfangen von Impulsen insbesondere des MLS-Typs, das eine erste Stufe der Signalabtastung für die Bestimmung von Werten von abgetasteten Abschnitten des Impulses und eines Empfangszeitpunkts für jeden abgetasteten Abschnitt sowie in Verbindung mit dieser Stufe für jeden Impuls eine Suche nach einem Maximalwert umfaßt, dadurch gekennzeichnet, daß es in der ersten Stufe darin besteht, für den Maximalwert den Wert des maximalen abgetasteten Abschnitts zu suchen, und daß es die folgenden Stufen enthält:

- eine zweite Stufe, um für einen empfangenen Impuls den Werteabstand zwischen dem Maximalwert der abgetasteten Abschnitte und einem im voraus definierten Schwellenwert, der einem Empfangsminimum entspricht, zu bestimmen,
- eine dritte Stufe, um diesen Abstand in Zonen zu unterteilen,
- eine vierte Stufe, um die Amplituden der abgetasteten Abschnitte sowie die Abtastzeitpunkte einer jeden Zone zu bestimmen,
- eine fünfte Stufe, um für jede Zone einen mittleren Zeitpunkt der Zone und eine mittlere Amplitude zu berechnen,
- eine sechste Stufe für die eventuelle Unterdrückung der Zone,
- eine siebte Stufe, um den Zeitpunkt des Empfangs des Impulses ausgehend von den mittleren Zonenzeitpunkten und den mittleren Amplituden auszugeben.

2. Verfahren nach Anspruch 1, dadurch gekennzeichnet, daß die siebte Stufe eine lineare Regression umfaßt.

3. Verfahren nach Anspruch 1 oder 2, dadurch gekennzeichnet, daß in der sechsten Stufe die Zonen, die keine signifikante Information beitragen, eliminiert werden.

4. Vorrichtung zum Ausführen des Verfahrens nach Anspruch 1, mit Abtastmitteln (5, 8), die Impulse des MLS-Typs empfangen und für jeden Impuls Abtastergebnisse ausgeben, die jeweils aus einem Wert des abgetasteten Abschnitts und einem Abtastzeitpunkt gebildet sind, und einem Verarbeitungselement (7), das ausgehend von einem Mikroprozessor gebildet ist, das die Abtastergebnisse empfängt und das für jeden Impuls einen Maximalwert sucht, dadurch gekennzeichnet, daß der Mikroprozessor so programmiert ist, daß er

- in der ersten Stufe als Maximalwert den maximalen abgetasteten Abschnitt sucht,
- in der zweiten Stufe für einen empfangenen Impuls den Werteabstand zwischen dem Wert des maximalen abgetasteten Abschnitts und einem im voraus definierten Schwellenwert, der einem Empfangsminimum entspricht, bestimmt,
- in einer dritten Stufe diesen Abstand in Zonen unterteilt,
- in einer vierten Stufe die Amplituden der abgetasteten Abschnitte und Zeitpunkte der abgetasteten Abschnitte in jeder Zone bestimmt,
- in einer fünften Stufe für jede Zone einen mittleren Zeitpunkt der Zone und eine mittlere Amplitude berechnet,
- in einer sechsten Stufe eine eventuelle Unterdrückung der Zone ausführt,
- in einer siebten Stufe den Zeitpunkt des Empfangs des Impulses ausgehend von den mittleren Zeitpunkten der Zone und den mittleren Amplituden ausgibt.

**Claims**

1. Method of receiving pulses of the M.L.S. type in particular, involving a first sampling step for determining sample values of the pulse and a time of reception for each sample and, together with this step, a search, for each pulse, for a maximum value, characterized in that it consists, in the first step, in searching out, as maximum value, the value of the maximum sample, and in that it includes the following steps:

- a second step for determining, for a received pulse, the gap in values between the maximum sample value and a predefined threshold corresponding to a reception minimum,
- a third step for splitting the said gap into zones,
- a fourth step for determining the sample amplitudes and the sample times of each zone,
- a fifth step for calculating, for each zone, a mean zone time and a mean amplitude,
- a sixth step of possible zone rejection,
- a seventh step for providing the time of reception of the pulse from the mean zone times and mean amplitudes.

2. Method according to Claim 1, characterized in that the seventh step involves a linear regression.

3. Method according to Claim 1 or 2, characterized in that, during the sixth step, the zones affording no significant information are eliminated.

4. Device for carrying out the method according to Claim 1, including sampling means (5, 8) for receiving pulses of the MLS type and for providing, for each pulse, samples each formed of a sample value and of a sample time and a processing module (7) which is constructed from a microprocessor, for receiving the samples and for searching, for each pulse, for a maximum value, characterized in that the microprocessor is programmed to,

- in the first step, search out, as maximum value, the value of the maximum sample,
- in a second step, determine for a received pulse the gap in values between the value of the maximum sample and a predefined threshold corresponding to a reception minimum,
- in a third step, split the said gap into zones,
- in a fourth step, determine the sample amplitudes and the sample times within each zone,
- in a fifth step, calculate, for each zone, a mean zone time and a mean amplitude,
- in a sixth step, perform a possible zone rejection,
- in a seventh step, provide the time of reception of the pulse from the mean zone times

and mean amplitudes.

FIG. 2

FIG. 1